# EUROPEAN PATENT APPLICATION

(11) **EP 1 670 064 A1**
(43) Date of publication of application: **14.06.2006**
(21) Application number: 04029487.8
(22) Date of filing: 13.12.2004
(51) Int. Cl.: H01L 29/93, H01L 29/94, H01L 21/329

(54) **Monolithically intergrated capacitor and method for manufacturing thereof**

(71) Applicant: Infineon Technologies AG, 81669 München (DE)
(72) Inventor: Arnborg, Torkel, 11436 Stockholm (SE); Johansson, Ted, 18262 Djursholm (SE)
(74) Representative: Schoppe, Fritz

(57) **Abstract**

A monolithically integrated capacitor having a variable capacitance, comprising a first semiconductor region structure (13; 91) doped to a first doping type (p), a second semiconductor region structure (11; 82) doped to a second doping type (n+) opposite the first doping type, a first electrode (16) of the capacitor connected to the semiconductor region structure, and a second electrode (15) of the capacitor connected to the second semiconductor region structure. The second semiconductor region structure is located in contact with, and laterally arranged at least on two opposite sides of, the first semiconductor region structure, and a boundary (14), preferably a planar boundary, between the first and second semiconductor region structures is angled with respect to a plane (17) having a laterally directed normal (18). Preferably, the second semiconductor region structure is partly or completely surrounding said first semiconductor region structure in a lateral plane.

## Description

### TECHNICAL FIELD OF THE INVENTION

The present invention generally relates to the field of integrated circuit technology, and more specifically the invention relates to a monolithically integrated capacitor and to a method of manufacturing the monolithically integrated capacitor.

### DESCRIPTION OF RELATED ART AND BACKGROUND OF THE INVENTION

Capacitors with a capacitance value, which can be changed electronically by altering for example a voltage over the capacitor, are sometimes called varactors, varicaps or tunable capacitors. The term varactor means variable reactance, but is often used for the special case of variable capacitance.

A tunable capacitor can in principle be based on any diode or transistor. Several variations on these structures have been proposed and patented to improve specific parameters of interest like for example the tuning range, see e.g. U.S. Patents Nos. 6,738,601; 6,420,939; 5,914,513; 5,220,194; and 4,490,772.

Tuning range values reported in the literature vary much depending on application and technology. For MOS based devices typical values are about two for standard solutions and about four using dedicated devices and reasonable control voltage swing, see e.g. J. Maget, M. Tiebout and R. Kraus, Influence of novel MOS varactors on the performance of a fully Integrated UMTS VCO in standard 0.25 µm CMOS Technology, IEEE Journal of, Vol. 37, Issue 7, July 2002, pp. 953-958. Pn-junction diode based devices have in general better performance but the tuning range is still limited to about 2-10, see for example the Internet page http://www.infineon.com/cmc_upload/documents/009/ 313/bby53 series.pdf, which page was accessible on November 30, 2004.

Tuning is performed to change frequency for a large variety of reasons, for example to switch between different channels, to combine different radio standards, and to select transmission propagation conditions.

In a common radio application a radio frequency (RF) signal at a receiver input is mixed with a local oscillator (LO) signal to get an intermediate frequency (IF) signal. This signal is usually the difference frequency, but could also be the sum frequency, depending on whether the radio architecture is of down-conversion or up-conversion type. The latter type has an advantage in that the image frequency is much more separated from the intermediate frequency. The tuning frequency of an RLC tank with fixed inductance is proportional to the inverse square root of the variable capacitance. To handle the frequency range [f_{RFmin}, f_{RFmax}] at an intermediate frequency f_{IF} a capacitance ratio C_{max/}Cₘᵢₙ = f_{LOmax} / f_{LOmin} = (f_{PFmax} - f_{IF}) / (f_{RFmin} - f_{IF}) is needed for the downconversion and a capacitance ratio Cₘₐₓ/Cₘᵢₙ = (f_{RPmax} + f_{IP}) / (f_{RFmin} + f_{IF}) is needed for upconversion. There are a number of cases where high tuning range is desirable; downconversion with high intermediate frequency, downconversion with low intermediate frequency, and when large differences exist between f_{RFmax} and f_{RFmin}. New applications in multi-standard phones, radar systems, and wireless systems will in many cases require large tuning range.

Large tuning range, which can not be realized using single devices, is today obtained using circuit design solutions wherein several varactors are connected to increase the range.

### SUMMARY OF THE INVENTION

It is an object of the present invention to provide a monolithically integrated capacitor having a variable capacitance, which is tunable over a larger range, than what is possible with the prior art capacitors described above.

It is a further object of the invention to provide such a capacitor, which has improved performance, and which is efficient, reliable, of low cost, and easy to manufacture and integrate.

It is in this respect a particular object of the invention to provide such a capacitor, which has high quality factor and low parasitic capacitance.

It is still a further object of the invention to a method for manufacturing a monolithically integrated capacitor, which fulfills any of the above objects.

These objects are, according to the present invention, attained by monolithically integrated capacitors and methods as claimed in the appended patent claims.

According to a first aspect of the present invention, there is provided a monolithically integrated capacitor having a variable capacitance, comprising a first semiconductor region structure doped to a first doping type, a second semiconductor region structure doped to a second doping type opposite the first doping type, a first electrode connected to the first semiconductor region structure, and a second electrode connected to the second semiconductor region structure. The second semiconductor region structure is located in contact with, and laterally arranged at least on two opposite sides of, the first semiconductor region structure, and a boundary between the first and second semiconductor region structures is angled with respect to a plane having a laterally directed normal. Advantageously, the second semiconductor region structure is laterally partly or completely surrounding the first semiconductor region structure. It may also be present beneath the first semiconductor region structure.

Preferably, the boundary between the first and second semiconductor region structures is essentially planar, and may form an angle of between about 5° and 25° with respect to the plane having the laterally directed normal.

Still preferably, all boundaries between the first and second semiconductor region structures are angled with respect to the plane having the laterally directed normal. The first semiconductor region structure may have an essentially circular, elliptic, quadratic, rectangular, or elongated shape as seen from above.

According to a second aspect of the invention there is provided a method for forming the above capacitor.

In one embodiment thereof the first semiconductor region structure is formed by (i) creating, preferably by means of dry etching such as reactive ion etching, an opening with at least one sloped wall in a substrate, (ii) filling the opening with semiconductor material, and (iii) planarizing an upper surface of the semiconductor material filled in the opening. The first semiconductor region structure may be doped in-situ during deposition, or may be ion implanted after deposition. The second semiconductor region structure is formed by doping sidewalls and the bottom of the opening to the second doping type prior to filling the formed opening with the semiconductor material. The doping is advantageously performed by angled ion implantation.

By means of the present invention monolithically integrated capacitors, which have an exceptionally large tuning range are realizable. Tuning ranges of e.g. 20-60 is feasible and should be compared with factors of 2-10 that are obtained by state-of-the-art capacitors today. The ultra high tuning range capacitors of the invention are very useful for voltage controlled oscillators in new applications wherein large tunability is required. By avoiding complicated circuit design solutions involving several varactors a much higher operating frequency is enabled. The voltage sensitivity is also exceptionally high, enabling varactor operation in future down-scaled low supply voltage technologies.

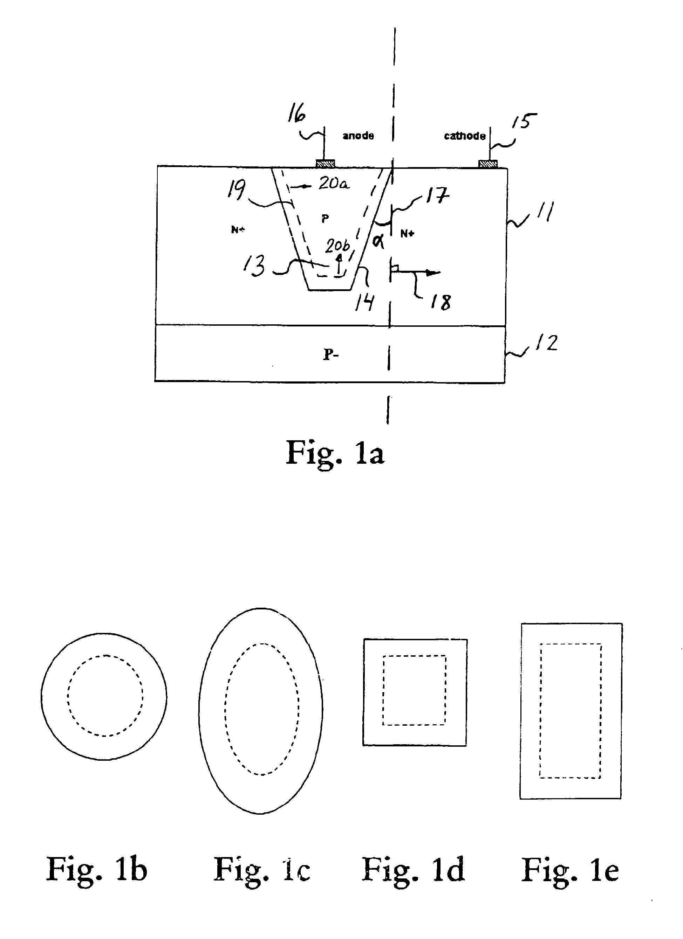

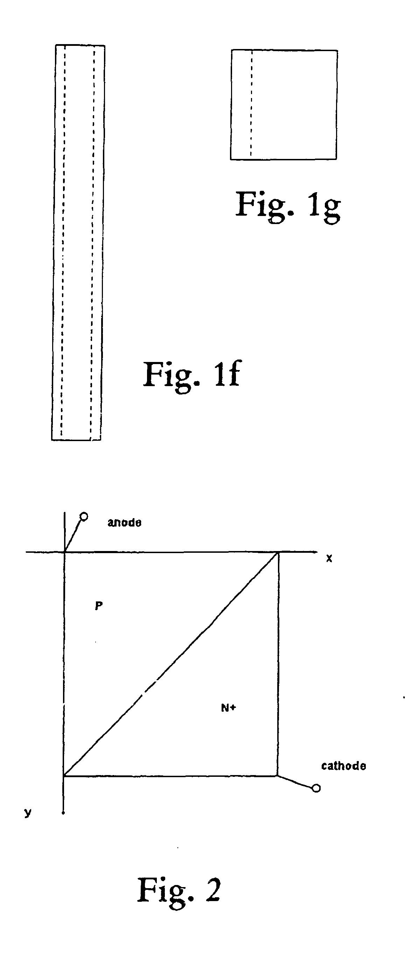

Further characteristics of the invention and advantages thereof will be evident from the detailed description of preferred embodiments of the present invention given hereinafter and the accompanying Figs. 1-12, which are given by way of illustration only, and are thus not limitative of the present invention.

### BRIEF DESCRIPTION OF THE DRAWINGS

Fig. 1a is a highly enlarged cross-sectional view of a monolithically integrated capacitor according to a preferred embodiment of the present invention, and Figs. 1b-g are schematic example layouts of the monolithically integrated capacitor of Fig. 1a according to various embodiments of the invention.
Fig. 2 is an enlarged cross-sectional view of part of a monolithically integrated capacitor as used in simulations of performance of the inventive tunable capacitor.
Fig. 3 shows three diagrams of hole concentration contours in the part of the capacitor as shown in Fig. 2 for three different bias voltages: from left to right 0 V, 3 V, and 6 V.
Figs. 4a-b are diagrams of capacitance versus cathode voltage for circular and quadratic layouts, respectively, of the capacitor illustrated in Fig. 2 for different sidewall slopes/trench depths.
Figs. 5a-b are diagrams of Q value versus cathode voltage for circular and quadratic layouts, respectively, of the capacitor illustrated in Fig. 2 for different sidewall slopes/trench depths.
Figs. 6-12 are highly enlarged cross-sectional views of a portion of a semiconductor structure during manufacturing of a monolithically integrated capacitor according to the present invention.

### DETAILED DESCRIPTION OF EMBODIMENTS

A first embodiment of a monolithically integrated capacitor with a variable capacitance according to a preferred embodiment of the present invention will be described with reference to Fig. 1.

The capacitor comprises a semiconductor region 11 doped to a first doping type, preferably N+, on top of a substrate 12, which is preferably doped to P-. A further semiconductor region 13 doped to a second doping type opposite the first doping type, preferably P, is arranged in an opening of the semiconductor region 11 doped to the first doping type.

The semiconductor region 13 doped to the second doping type is in physical contact with, and is laterally at least partly surrounding, the semiconductor region 11 doped to the first doping type. Further, the semiconductor region 11 is present beneath the semiconductor region 13. Thus, the boundary 14 between the semiconductor regions 11, 13 constitutes a pn-junction of the capacitor. Further, electrodes 15, 16 are provided for connection of the respective semiconductor regions 11, 13.

According to the present invention the boundary 14 between the semiconductor regions 11, 13 is angled with respect to a plane 17 having a laterally directed normal 18.

Preferably, the surrounding semiconductor region 11 surrounds the centrally located semiconductor region completely in a lateral plane.

The boundary between the semiconductor regions 11, 13 is preferably essentially planar, but may alternatively be curved.

The boundary may define an angle α of between about 5° and about 25° with respect to the plane 17 having the laterally directed normal 18.

Figs. 1b-g show schematic example layouts of the monolithically integrated capacitor of Fig. 1a according to various embodiments of the invention. Solid lines indicate the layout of the centrally located semiconductor region 13 at the semiconductor surface, whereas dashed lines indicate the layout of the centrally located semiconductor region 13 at the bottom thereof.

As illustrated in Figs. 1b-1e, the semiconductor region 13 may have an essentially circular, elliptic, quadratic, and rectangular shape, respectively, as seen from above. All boundaries between the semiconductor regions 11, 13 are angled with respective to the plane 17 having the laterally directed normal 18.

Fig. 1f shows an embodiment wherein the semiconductor region 13 is narrow and elongated and has the longer sidewalls inclined at an angle with respective to the plane 17 having the laterally directed normal 18. The shorter sidewalls are essentially vertical.

Fig. 1g, finally, shows an embodiment wherein the semiconductor region 13 is quadratic and has only one sidewall that is angled. All other sidewalls of the semiconductor region 13 are essentially vertical.

The surrounding semiconductor region 11 may have an essentially annular shape as seen from above.

The variable capacitance operation is achieved by means of a depletion layer boundary, denoted by reference numeral 19 in Fig. 1a, being provided to be moved in the centrally located semiconductor region 13 depending on a voltage applied over the capacitor. Thanks to the shape of the capacitor, the depletion layer boundary 19 is moved horizontally in an upper portion of the semiconductor region 13 and vertically in a lower portion of the semiconductor region 13 as being illustrated by arrows 20a-b.

When more than one sidewall of the capacitor is angled, the depletion layer boundary is moved in three dimensions. In this version, the capacitor may be said to combine two or more back biased pn-junctions with depletion layers that interact with each other. Full depletion is achieved for a relatively small voltage swing.

The capacitor of the present invention provides a larger capacitance variation for a given voltage swing similarly as a how a reduced doping of the centrally located semiconductor region 13 would affect the capacitance variation, but without lowering the quality factor.

The inventive capacitor can be implemented in a trench using conventional processing equipment, which will be detailed later in this description.

It shall further be appreciated that the doping types may be reversed, so that the centrally located semiconductor region 13 is doped to N, whereas the surrounding semiconductor region 11 is doped to P+.

It shall still further be appreciated that the capacitor of the present invention may be formed on an isolator structure, such as an isolation structure of an SOI substrate, where the centrally located semiconductor region 13 reached down to or into the isolation structure so that the surrounding semiconductor region 11 is not present beneath the centrally located semiconductor region 13.

It shall yet further be appreciated that the inventive capacitor may comprise two (or more) semiconductor regions doped to e.g. N+, arranged located in contact with, and laterally arranged at least on two opposite sides of, the centrally located semiconductor region doped to e.g. P. Thus, the invention can be generalized to that a semiconductor region structure doped to a first doping type, e.g. N+, is located in contact with, and laterally arranged at least on two opposite sides of, a semiconductor region structure doped to an opposite doping type, e.g. P, wherein a boundary between the first and second semiconductor region *structures* is angled with respect to a plane having a laterally directed normal. Preferably, however, the semiconductor region structure doped to the first doping type is located to laterally partly or completely surround the semiconductor region structure doped to the opposite doping type.

It shall still further be appreciated that features of the different embodiments of the present invention may be combined in numerous manners to for yet further inventive embodiments.

Fig. 2 is an enlarged cross-sectional view of part of a monolithically integrated capacitor as used in simulations of performance of the inventive tunable capacitor. For the simulations only half the structure is needed assuming symmetry. Note, that this embodiment lacks a horizontal bottom surface. The doping concentrations may be in the range of 10¹⁴-10¹⁸ cm⁻³ in the centrally located semiconductor region and in the range of 10¹⁹-10²¹ cm⁻³ in the surrounding semiconductor region.

Two layouts are studied: circular and extended linear shapes. In the former layout, the centrally located semiconductor region has the general shape of a cone, whereas in the latter layout, the centrally located semiconductor region has the general shape of a long linear v groove or trench.

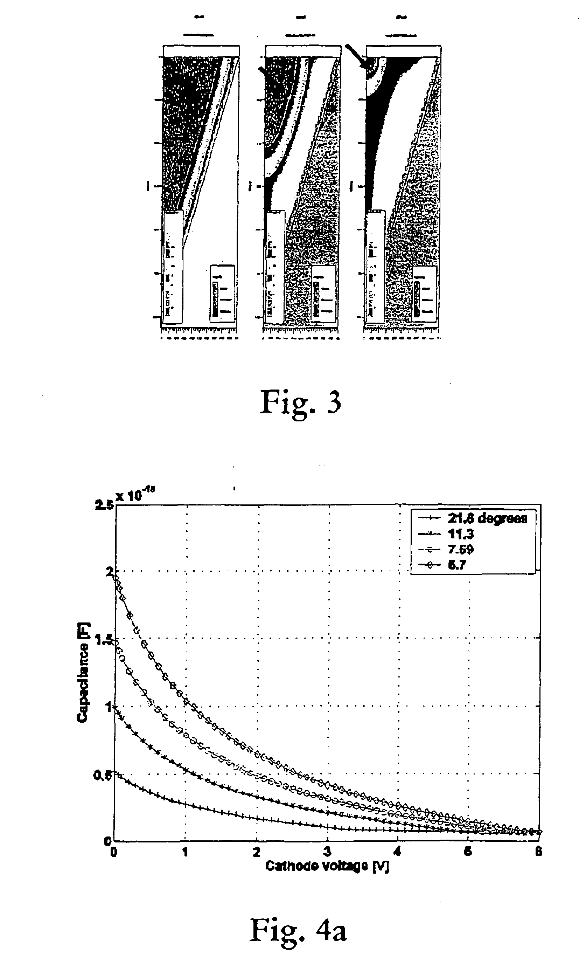

Fig. 3 shows three diagrams of hole concentration contours in the part of the capacitor as shown in Fig. 2 for three different bias voltages: from left to right 0 V, 3 V, and 6 V, and the boundary is marked with an arrow.

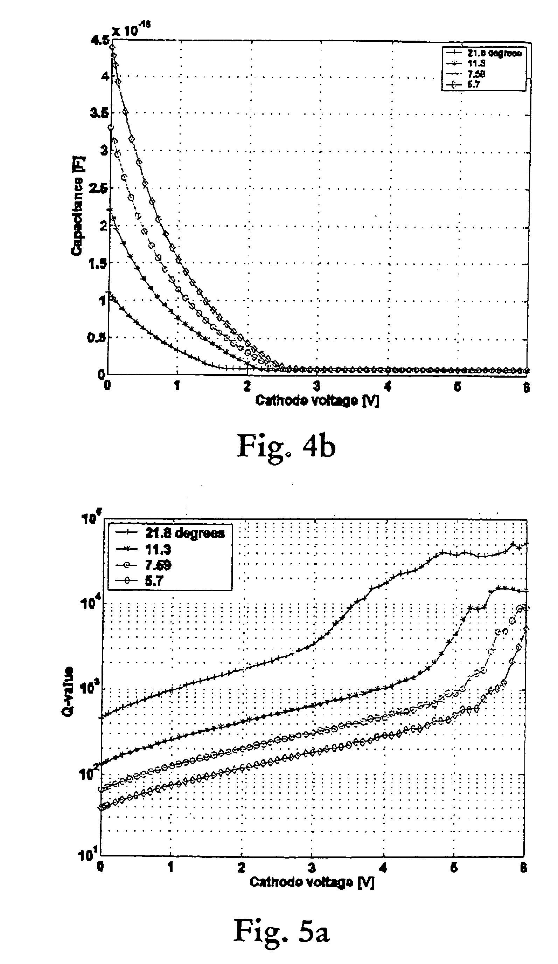

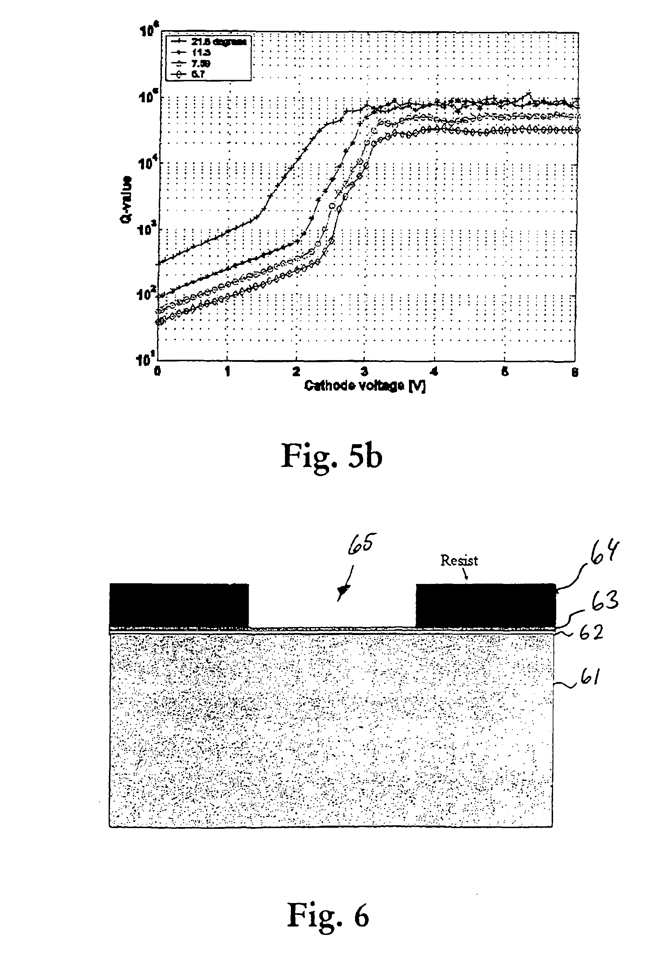

Figs. 4a-b are diagrams of capacitance versus cathode voltage for circular and quadratic layouts, respectively, of the capacitor illustrated in Fig. 2 for different sidewall slopes/trench depths, and Figs. 5a-b are diagrams of Q value at a frequency of 1 GHz versus cathode voltage for circular and quadratic layouts, respectively, of the capacitor illustrated in Fig. 2 for different sidewall slopes/trench depths. Fixed doping levels on either sides of the pn-junction are assumed.

The sidewall slopes range from 6.7° to 21.8° with respect to a vertical plane. The different angles were obtained by changing the trench depth keeping the width at the semiconductor surface constant.

From Figs 4a-b and 5a-b it can be concluded that high tuning ranges, i.e. ranges of about 10-50, can be achieved with acceptable Q values, i.e. Q values higher than 60, and for such a small voltage swing as a few volts.

Further, it is well-known that hyper-abrupt junctions improve varactor diodes compared to abrupt junctions. It is quite obvious that those hyper-abrupt junctions can be used in this invention, and that the improvement from doping profile will add to that from the geometry.

A method of manufacturing a monolithically integrated tunable capacitor of the above kind will be described below, with reference to Figs. 6-12.

The capacitor can be integrated into silicon CMOS, BiCMOS or bipolar process flows as a module, which is typically inserted early in the process flow; for a CMOS process it may constitute the first steps, and in a BiCMOS/bipolar process the module may be inserted after subcollector formation and epitaxial deposition, possibly before the isolation modules.

A p- type doped monocrystalline silicon wafer substrate 61 is provided, on top of which a thin oxide layer 62 and a thin nitride layer 63 are formed. The oxide layer 62 may be 10-20 nm thick, whereas the nitride layer 63 may be 50-200 nm thick. A photo mask 64 is deposited and patterned to form an opening 65, which defines the capacitor structure. The resulting structure is illustrated in Fig. 6. The opening 65 may be circular as seen from above, it may be rectangular and extend into the plane of Fig. 6, or it may have other layout. Reference is made to Figs. 1b-g.

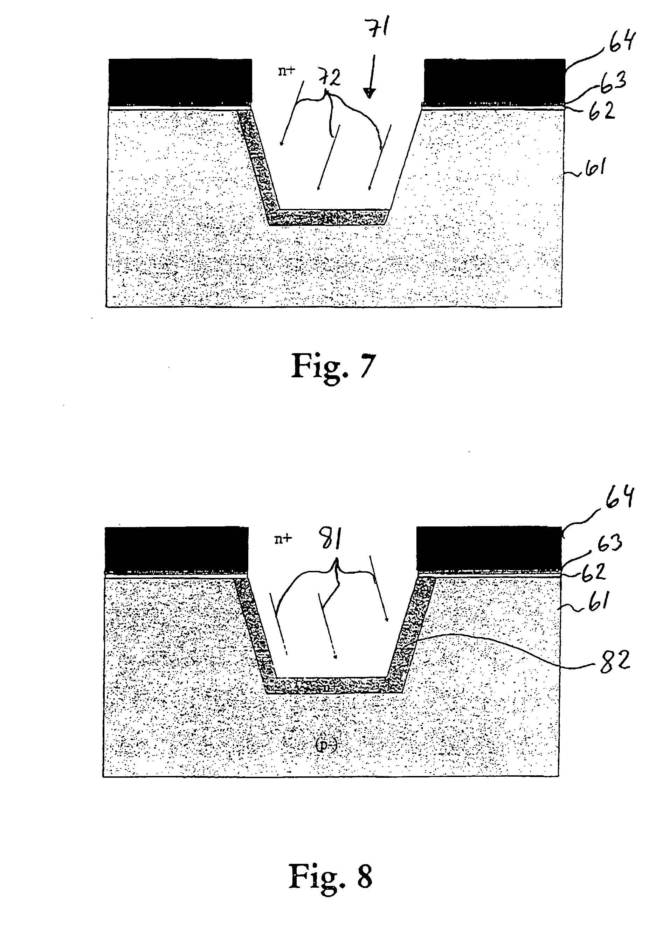

A opening 71 with sloped walls 72 is next formed through the thin oxide and nitride layers 62 and 63, and into the substrate 61 using dry etching, e.g. reactive ion etching. By tuning the etching parameters, the depth of the opening and the angle of the sloped sidewalls can be precisely controlled. With the patterned photo mask 64 still present on the wafer, angled ion implantation is used to dope the sidewalls and the bottom of the structure to n+. Typically, the wafer is implanted four times with 90° rotation between the implantations. Implantation towards the left hand side of the opening 71 is illustrated by arrows 72 in Fig. 7, whereas implantation towards the right hand side of the opening 71 is illustrated by arrows 81 in Fig. 8. As a result an n+ doped region 82 is formed in the sidewalls and at the bottom of the opening 71.

The photo mask 64 is removed and the structure is given a short heat treatment to drive and active the implanted dopants, as well as restoring the crystal quality of the substrate material. The heat treatment is typically started in an oxidizing ambient, to create a oxide capping layer for the dopants.

After removal of the capping layer, silicon is epitaxially deposited on the structure. The silicon will grow epitaxially in the opening 71, while polycrystalline silicon will be formed on top the nitride layer 63. The silicon is preferably p- doped in-situ, but it is possible to create the p- doping using an additional ion implantation.

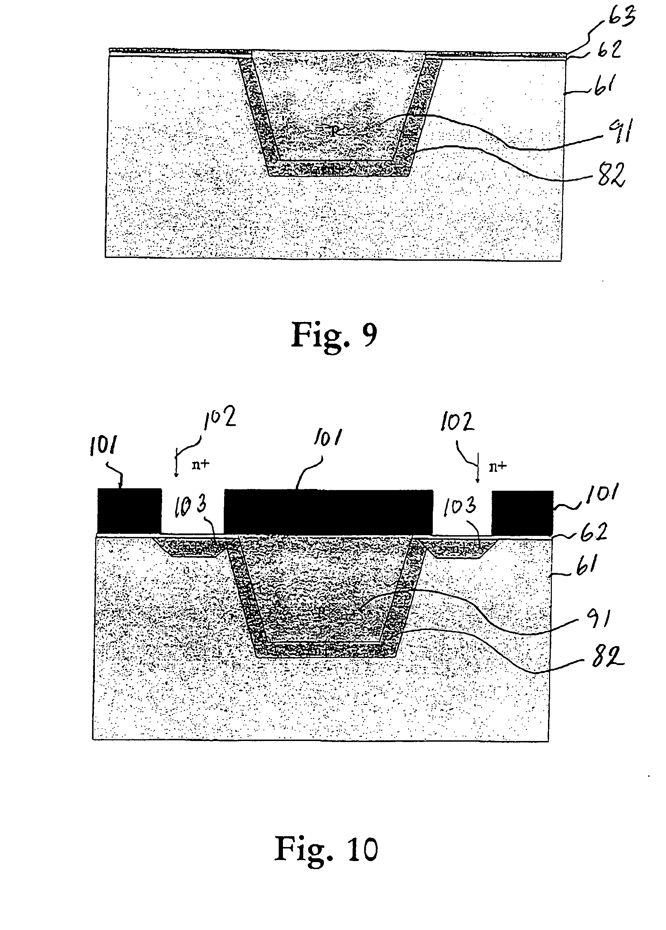

The epitaxially deposited silicon is planarized using chemical-mechanical polishing (CMP) or reactive ion etching (RIE), and all polycrystalline silicon on the surface of the structure is removed, leaving only a monocrystalline silicon region 91 in the opening 71. The nitride layer 63 is necessary as a mechanical stopping layer using CMP or etch stop layer using RIE. The resulting structure is illustrated in Fig. 9.

The nitride layer 63 is removed by means of etching, preferably a wet etching having high selectivity to both silicon and silicon oxide. An n+ implantation mask 101 is patterned as illustrated in Fig. 10 to enable formation of contacts. Ion implantation with arsenic or phosphorus is made through the implantation mask 101 as being illustrated by arrows 102. As a result, n+ doped contact regions 103 are formed. The implantation mask 101 is aligned so that the n+ doped region 82 formed in the sidewalls and at the bottom of the opening 71 is in contact with the n+ doped contact regions 103 as can be seen in Fig. 10. Then, the implantation mask 101 is removed.

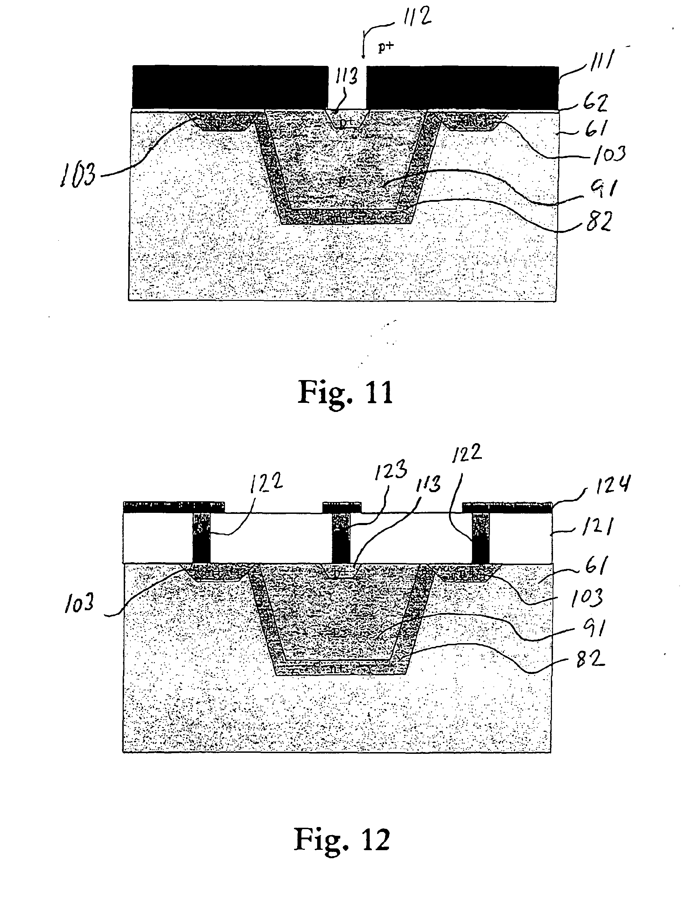

Similarly, a p+ implantation mask 111 is patterned as illustrated in Fig. 11 to enable formation of a contact to the p- doped polycrystalline silicon 91. Ion implantation with boron is made through the implantation mask 111 as being illustrated by arrows 112. As a result, a p+ doped contact regions 113 is formed. Then, the implantation mask 111 is removed.

It shall be stressed, that for most process flow, there are suitable process steps available in the baseline flow, which can be used for contacting the structure. The n+ and p+ contacts 112 and 113 may for instance be formed simultaneously with source/drain implantations for NMOS and PMOS transistors, respectively.

Finally, a passivation oxide layer 121 is formed on the surface of the structure, metal contacts 122, 123 are formed through the passivation layer 121 to the n+ and p+ contacts 112 and 113, and a metallization pattern 124 is formed.

It shall be appreciated that e.g. in a BiCMOS process using a buried collector layer and a collector plug structure, the above method may be modified so that the n+ contact 112 is not formed in contact with sidewall portions of the n+ doped region 82, but separated from there. Instead, electrical connection from the n+ contact 112 to the n+ doped region 82 is formed via an n+ doped plug structure and an n+ doped buried region.

## Claims

1. A monolithically integrated capacitor having a variable capacitance, comprising:
- a first semiconductor region structure (13; 91) doped to a first doping type (p),
- a second semiconductor region structure (11; 82) doped to a second doping type (n+) and located in contact with, and laterally arranged at least on two opposite sides of, said first semiconductor region structure, said second doping type being opposite to said first doping type,
- a first electrode (16) of said capacitor connected to said first semiconductor region structure, and
- a second electrode (15) of said capacitor connected to said second semiconductor region structure, **characterized in that**
- a boundary (14) between said first and second semiconductor region structures is angled with respect to a plane (17) having a laterally directed normal (18).

2. The capacitor of claim 1, wherein said boundary between said first and second semiconductor region structures is essentially planar.

3. The capacitor of claim 1 or 2, wherein said boundary between said first and second semiconductor region structures defines an angle (α) of between about 5° and about 25° with respect to said plane having a laterally directed normal.

4. The capacitor of any of claims 1-3, wherein said second semiconductor region structure is located to partly or completely surround said first semiconductor region structure in a lateral plane.

5. The capacitor of any of claims 1-4, wherein all boundaries between said first and second semiconductor region structures are angled with respect to a plane having a laterally directed normal.

6. The capacitor of any of claims 1-5, wherein said first semiconductor region structure has an essentially circular, elliptic, quadratic, rectangular, or elongated shape as seen from above.

7. The capacitor of any of claim 1-6, wherein said second semiconductor region structure has an essentially annular shape as seen from above.

8. The capacitor of any of claims 1-7, wherein a depletion layer boundary (19) is provided to be moved in said first semiconductor region structure depending on a voltage applied over said capacitor to thereby obtain said variable capacitance.

9. The capacitor of claim 8, wherein said depletion layer boundary is provided to be moved (20a) horizontally in a lower portion of said first semiconductor region structure and vertically (20b) in an upper portion of said first semiconductor region structure.

10. The capacitor of claim 8 or 9, wherein said depletion layer boundary is provided to be moved three-dimensionally in said first semiconductor region structure.

11. A method for manufacturing a monolithically integrated capacitor having a variable capacitance, comprising the steps of:
- forming a first semiconductor region structure (13, 91) doped to a first doping type (p),
- forming a second semiconductor region structure (11, 82) doped to a second doping type (n+) and located in contact with, and laterally arranged at least on two opposite sides of, said first semiconductor region structure, said second doping type being opposite to said first doping type,
- forming a first electrode (16) of said capacitor connected to said first semiconductor region structure, and
- forming a second electrode (15) of said capacitor connected to said second semiconductor region structure, **characterized in that**
- said first and second semiconductor region structures are formed so that a boundary (14) between them is angled with respect to a plane (17) having a laterally directed normal (18).

12. The method of claim 11, wherein said second semiconductor region structure is formed to partly or completely surround said first semiconductor region structure in a lateral plane.

13. The method of claim 11 or 12, wherein said step of forming said first semiconductor region structure (91) includes the steps of:
- forming, preferably by means of dry etching such as reactive ion etching, an opening (71) with at least one sloped wall in a substrate,
- filling said formed opening with semiconductor material, and
- planarizing an upper surface of said semiconductor material filled in said opening.

14. The method of claim 13, wherein said step of forming said second semiconductor region structure (82) includes the step of:
- doping (72, 81) sidewalls and the bottom of said formed opening to said second deping type prior to filling said formed opening with said semiconductor material, said doping being performed by angled ion implantation.

15. The method of any of claims 11-14, wherein said first semiconductor region structure is formed to have an essentially circular, elliptic, quadratic, rectangular, or elongated shape as seen from above.

## Amended claims

### Amended claims in accordance with Rule 86(2) EPC.

**1.** A monolithically integrated capacitor having a variable capacitance, comprising:
- a substrate (11; 61);
- a first semiconductor region structure (13; 91) filling a recess in the substrate and doped to a first doping type (p),
- a second semiconductor region structure (11; 82) in said substrate (11; 61) doped to a second doping type (n+) and located in contact with, and laterally arranged at least on two opposite sides of, said first semiconductor region structure, said second doping type being opposite to said first doping type, the doping level of the second semiconductor region structure being higher than the level of the first semiconductor region structure;
- a first electrode (16) of said capacitor connected to said first semiconductor region structure, and
- a second electrode (15) of said capacitor connected to said second semiconductor region structure,
- wherein a boundary (14) between said first and second semiconductor region structures is angled with respect to a plane (17) having a laterally directed normal (18).

**2.** The capacitor of claim 1, wherein said boundary between said first and second semiconductor region structures is essentially planar.

**3.** The capacitor of claim 1 or 2, wherein said boundary between said first and second semiconductor region structures defines an angle (α) of between about 5° and about 25° with respect to said plane having a laterally directed normal.

**4.** The capacitor of any of claims, 1-3, wherein said second semiconductor region structure is located to partly or completely surround said first semiconductor region structure in a lateral plane.

**5.** The capacitor of any of claims 1-4, wherein all boundaries between said first and second semiconductor region structures are angled with respect to a plane having a laterally directed normal.

**6.** The capacitor of any of claims 1-5, wherein said first semiconductor region structure has an essentially circular, elliptic, quadratic, rectangular, or elongated shape as seen from above.

**7.** The capacitor of any of claim 1-6, wherein said second semiconductor region structure has an essentially annular shape as seen from above.

**8.** The capacitor of any of claims 1-7, wherein a depletion layer boundary (19) is provided to be moved in said first semiconductor region structure depending on a voltage applied over said capacitor to thereby obtain said variable capacitance.

**9.** The capacitor of claim 8, wherein said depletion layer boundary is provided to be moved (20a) horizontally in a lower portion of said first semiconductor region structure and vertically (20b) in an upper portion of said first semiconductor region structure.

**10.** The capacitor of claim 8 or 9, wherein said depletion layer boundary is provided to be moved three-dimensionally in said first semiconductor region structure.

**11.** A method for manufacturing a monolithically integrated capacitor having a variable capacitance, comprising the steps of:
- forming a first semiconductor region structure (13, 91) doped to a first doping type (p) by forming, preferably by means of dry etching such as reactive ion etching, an opening (71) with at least one sloped wall in a substrate, filling said formed opening with semiconductor material, and planarizing an upper surface of said semiconductor material filled in said opening,
- forming a second semiconductor region structure (11, 82) doped to a second doping type (n+) and located in contact with, and laterally arranged at least on two opposite sides of, said first semiconductor region structure, said second doping type being opposite to said first doping type, the doping level of the second semiconductor region structure being higher than that of the first semiconductor region structure,
- forming a first electrode (16) of said capacitor connected to said first semiconductor region structure, and
- forming a second electrode (15) of said capacitor connected to said second semiconductor region structure,
- wherein said first and second semiconductor region structures are formed so that a boundary (14) between them is angled with respect to a plane (17) having a laterally directed normal (18).

**12.** The method of claim 11, wherein said second semiconductor region structure is formed to partly or completely surround said first semiconductor region structure in a lateral plane.

**13.** The method of claim 11, wherein said step of forming said second semiconductor region structure (82) includes the step of:
- doping (72, 81) sidewalls and the bottom of said formed opening to said second doping type prior to filling said formed opening with said semiconductor material, said doping being performed by angled ion implantation.

**14.** The method of any of claims 11-13, wherein said first semiconductor region structure is formed to have an essentially circular, elliptic, quadratic, rectangular, or elongated shape as seen from above.
